# EUROPÄISCHE PATENTSCHRIFT

(11) **EP 0 588 050 B1**
(45) Veröffentlichungstag und Bekanntmachung des Hinweises auf die Patenterteilung: **29.12.1997**
(21) Anmeldenummer: 93112719.5
(22) Anmeldetag: 09.08.1993
(51) Int. Cl.: H04J 3/06, H04L 7/00

(54) **Anordnung zur Erzeugung eines Taktsignals mit bitgenauen Lücken**
Arrangement for generating a clock signal having missing pulses with a bit precision
Dispositif pour la génération d'un signal d'horloge présentant des absences d'impulsions avec une précision de bit

(30) Priorität: 18.08.1992 DE 4227285
(43) Veröffentlichungstag der Anmeldung: 23.03.1994
(73) Patentinhaber: SIEMENS AKTIENGESELLSCHAFT, 80333 München (DE)
(72) Erfinder: Rathgeber, Max Dipl.-Ing., D-82024 Taufkirchen (DE); Fütterer, Augustin Dipl.-Ing. (FH), D-85386 Eching/Dietersheim (DE)

(56) Entgegenhaltungen:
- EP-A- 0 100 076
- EP-A- 0 419 895
- FR-A- 2 473 235
- US-A- 2 996 248
- US-A- 4 651 103
- US-A- 4 672 299
- SIEMENS TELCOM REPORT. Bd. 11, Nr. 4 , Juli 1988 , MÜNCHEN DE Seiten 140 - 143 BEETZ ET AL. 'ISDN PRÄZISE SYNCHRONISIEREN'

## Beschreibung

Die Erfindung betrifft ein Verfahren und eine Anordnung zur Taktsignalerzeugung entsprechend dem Oberbegriff der Patentansprüche 1 und 3.

Eine solche Taktsignalerzeugung ist z.B. aus US-A-4 651 103 bekannt.

Die Erzeugung von Taktsignalen mittels Phasenregelschleifen ist seit langem bekannt. Phasenregelschleifen, die auch als Nachlaufsychronisation oder als Phasenregelkreise bezeichnet werden, enthalten einen Phasendetektor zum Vergleich des erzeugten Taktsignals mit einem Referenzsignal sowie dem Phasendetektor nachgeschaltet, die Reihenschaltung eines Schleifenfilters und eines spannungsgesteuerten Oszillators. Derartige Phasenregelschleifen sind in Tietze, Schenk "Halbleiterschaltungstechnik" 9. Auflage, Springer-Verlag Berlin usw., Seiten 954 - 966 detailliert beschrieben. Dabei ist auf Seite 966 auch bereits der Fall dargestellt, daß der spannungsgesteuerte Oszillator auf einer Frequenz schwingt, die ein ganzzahliges Vielfaches der am Referenzeingang des Phasendiskriminators anstehenden Schwingung ist. Das Ausgangssignal des spannungsgesteuerten Oszillators wird in diesem Falle einem Zähler oder Frequenzteiler zugeführt, der eine Frequenzteilung von der Schwingfrequenz des spannungsgesteuerten Oszillators auf die Frequenz des Referenzsignals vornimmt und dessen Ausgang mit einem Vergleichseingang des Phasendiskriminators verbunden ist.

In der digitalen Übertragungstechnik, insbesondere bei der Taktversorgung von kombinierten Multiplex- und Vermittlungseinrichtungen für digitale Signale besteht Bedarf nach einem Taktsignal im Bereiche von beispielsweise einigen 10 MHz, in welchem durch fehlende Impulse zusätzlich ein Rahmentakt mit einer Frequenz von einigen kHz markiert ist. Die Ansprüche an die Genauigkeit der Markierung sind sehr hoch, da der Rahmentakt bitgenau stimmen muß, sowohl Bittakt als auch Rahmentakt in Abhängigkeit von dem Normaltakt der zugeordneten Übertragungs- oder Vermittlungseinrichtung erzeugt werden müssen und die gesamte Einrichtung mit Gestellverdrahtungslängen extern von maximal 50 m und intern von maximal 2 m erhebliche Laufzeitprobleme mit sich bringt. Dazu kommt, daß aus Zuverlässigkeitsgründen die Anordnung zur Taktsignalerzeugung neben der Betriebsbaugruppe eine zu dieser synchron laufende Ersatzbaugruppe aufweisen muß und bei der Umschaltung von der Betriebsbaugruppe auf die Ersatzbaugruppe keine Störungen der Multiplex- und Vermittlungseinrichtung auftreten dürfen, aber bei der Ersatzschaltung des von der Multiplex- und Vermittlungseinrichtung stammenden Normaltaktes sowohl Unterbrechungen als auch beliebig große Phasensprünge auftreten können.

Die Aufgabe der Erfindung besteht also darin, ein Verfahren und eine Anordnung zur Taktsignalerzeugung der eingangs erwähnten Art so weiterzubilden, daß sie die vorstehend geschilderten Anforderungen erfüllt, wobei zusätzlich möglicherweise unterschiedliches Einschwingverhalten der Phasenregelschleifen der Betriebsbaugruppe und der Ersatzbaugruppe den Betrieb insgesamt nicht stören darf, außerdem muß die Möglichkeit bestehen, daß bei Störungen die jeweils gestörte Baugruppe erkannt und auf die ungestörte automatisch umgeschaltet wird.

Die Aufgabe wird erfindungsgemäß durch ein Verfahren und eine Anordnung der eingangs erwähnten Art gelöst, die durch die im Kennzeichen der Patentansprüche 1 und 3 enthaltenen Merkmale weitergebildet ist. Die erfindungsgemäße Lösung bietet in vorteilhafter Weise die Möglichkeit, nur handelsübliche Bausteine zu verwenden, deren Langzeitverhalten und damit deren Zuverlässigkeit bekannt sind. Durch die gewählte Schaltungstechnik werden nur wenige Bausteine bei einer vergleichsweise hohen Frequenz betrieben, so daß die Verwendung von Emitter gekoppelter Logik (ECL-Schaltungen) stark zugunsten von MOS-Bausteinen reduziert ist. Damit ergibt sich in vorteilhafter Weise eine geringere Verlustleistung und damit neben der leichten Wärmeableitung auch eine erhöhte Zuverlässigkeit der gesamten Anordnung. Weiterbildungen der erfindungsgemäßen Anordnung im Hinblick auf geringe Auswirkungen von Störungen und genauere Funktionen sind in den Patentansprüchen 2 bis 4 näher beschrieben.

Die Erfindung soll in folgendem anhand eines in der Zeichnung dargestellten Ausführungsbeispiels näher erläutert werden. Dabei zeigen
- Fig. 1: ein einfaches Blockschaltbild der erfindungsgemäßen Anordnung zur Takterzeugung,
- Fig. 2: das Blockschaltbild der in Fig. 1 enthaltenen Phasenregelschleife und
- Fig. 3: das Blockschaltbild des in Fig. 1 enthalten Lückentaktgenerators.

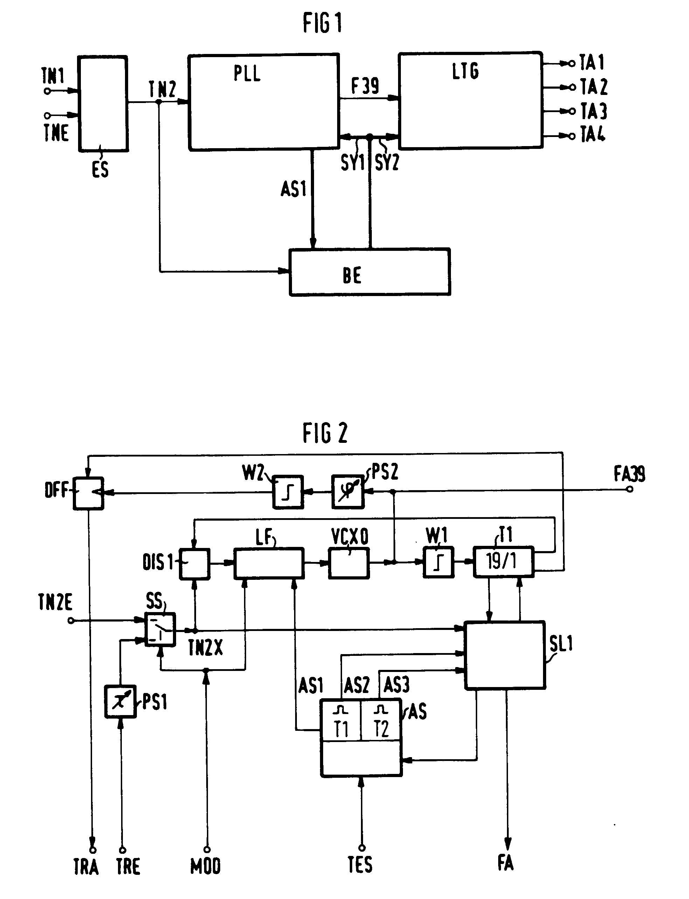

Die in der Fig. 1 dargestellte gesamte Anordnung zur Takterzeugung enthält als Funktionsblöcke die Eingangsschaltung ES, die Phasenregelschleife PLL, den Lückentaktgenerator LTG und die Betriebs-Ersatz-Logikschaltung BE. Die Eingangsschaltung ES enthält Eingänge für einen ersten Normaltakt TN1 und einen aus Sicherheitsgründen parallel geführten Normaltakt TNE. Die Eingangsschaltung enthält Selektionsmittel zur Störbefreiung der Normaltakteingänge sowie die Umschalteinrichtungen zum Ersatzschalten. Die Betriebs-Ersatz-Logikschaltung BE legt den Betriebs- bzw. Ersatzstatus der Baugruppen fest, die entsprechend in den folgenden Ausführungen als Betriebs- oder Ersatzbaugruppen bezeichnet werden.

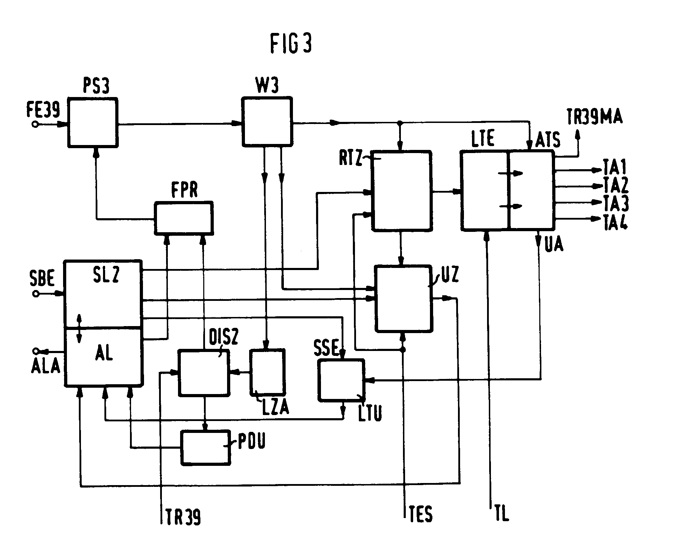

Das störbefreite Normaltaktsignal TN2 wird vom Ausgang der Eingangsschaltung ES an einen zugeordneten Eingang der Phasenregelschleife PLL weitergeleitet, deren Innenschaltung in der Fig. 2 näher dargestellt ist. Außerdem wird das Ausgangssignal TN2 der Eingangsschaltung ES an einem Takteingang der Betriebs-Ersatz-Logik BE abgegeben. Die Phasenregelschleife PLL erzeugt ein sinusförmiges Ausgangssignal mit einer Frequenz von etwa 39 MHz, das an den Lückentaktgenerator LTG weitergeleitet wird. Außerdem erzeugen die in der Phasenregelschleife enthaltenen Überwachungseinrichtungen eine Reihe unterschiedlicher Alarmsignale, die als erstes Alarmsignal AS1 zusammengefaßt an einen zugeordneten Eingang der Betriebs-Ersatz-Logik BE weitergeleitet werden. Der Lückentaktgenerator LTG enthält einen Frequenzteiler zur Erzeugung eines Rahmensignals, das als 2 kHz-Taktsignal die Einblendung der Lücken im 39 MHz-Taktsignal F39 veranlaßt. Die Blockschaltung des Lückentaktgenerators LTG ist in der Fig. 3 genauer dargestellt, als Ausgänge des Lückentaktgenerators LTG sind der erste bis vierte Taktausgang TA1...TA4 vorgesehen.

Die Betriebs-Ersatz-Logikschaltung BE enthält die zum Ersatzschalten notwendigen Umschalteinrichtungen und verfügt über weitere, in der Zeichnung nicht dargestellte Steuereingänge und Steuerausgänge. Von der Betriebs-Ersatz-Logikschaltung BE wird ein erstes und ein zweites Synchronsteuersignal SY1,SY2 erzeugt, die an die Phasenregelschleife PLL bzw. den Lückentaktgenerator LTG zu deren Synchronisationssteuerung abgegeben werden. Die Synchronisationssteuerung ist dabei insbesondere für die Erstsynchronisation nach dem Einschalten der gesamten Anordnung notwendig, da während der Erstsynchronisation die in dem Lückentaktgenerator enthaltenen Frequenzteiler im Gegensatz zu den der Phasenregelschleife definiert zu setzen sind, außerdem ist es durch einen mit der Betriebs-Ersatz-Logikschaltung BE verbundenen handbetätigten Schalter möglich zu Überwachungszwecken eine Ersatzschaltung vornehmen zu können.

Der in Fig. 2 dargestellte Funktionsblock Phasenregelschleife PLL weist eingangsseitig einen gesteuerten Umschalter SS auf, an dessen einem Eingang das von der Eingangsschaltung ES störbefreite Normaltaktsignal TN2 und an dessen anderem Eingang ein Taktreferenzsignal TRE anliegt, das einen ersten einstellbaren Phasenschieber PS1 durchlaufen hat. Am Steuereingang des gesteuerten Umschalters SS liegt ein Steuersignal MOD an, das von der Betriebs-Ersatz-Locikschaltung BE stammt. Der Ausgang des gesteuerten Umschalters ist mit einem Eingang eines ersten Phasendiskriminators DIS1 sowie mit einem Eingang einer ersten Setzlogik SL1 verbunden. Der Ausgang des ersten Phasendiskriminators DIS1 ist über ein Schleifenfilter LF mit dem Steuereingang eines spannungsgesteuerten Oszillators VCXO verbunden, dessen Ausgang über einen ersten Sinus-MOS-Wandler W1 mit dem Eingang eines ersten Frequenzteilers T1 sowie über einen zweiten Phasenschieber PS2 und einen zweiten Sinus-MOS-Wandler W2 mit dem Takt-Eingang eines D-Flipflops DFF verbunden ist. Ein erster Ausgang des ersten Frequenzteilers Tl ist mit einem zweiten Eingang des ersten Phasendiskriminators DIS1 verbunden, während an einen zweiten Ausgang des ersten Frequenzteilers T1 der D-Eingang des D-Flipflops DFF angeschlossen ist. Mit einem der beiden Ausgänge des D-Flipflops DFF ist ein Taktreferenzausgang TRA verbunden, an den der Taktreferenzsignaleingang der Ersatzbaugruppe angeschlossen ist. Das Schleifenfilter LF weist zwei Umschalteingänge auf, wobei der erste mit dem Eingang MOD und der andere mit einem ersten Ausgang AS1 einer Schaltungsanordnung zur Ablaufsteuerung AS verbunden ist. Ein zweiter und ein dritter Ausgang AS2, AS3 dieser Schaltungsanordnung der Ablaufsteuerung sind mit zugeordneten Eingängen der ersten Setzlogik SL1 verbunden, während ein erster Ausgang dieser Setzlogik mit einem zugeordneten Eingang der Ablaufsteuerung AS und ein weiterer Ausgang als Fehlerausgang FA mit einem zugeordneten Eingang der Betriebs-Ersatz-Logikschaltung BE verbunden ist. Mit weiteren Ausgängen der Betriebs-Ersatz-Logikschaltung BE sind der Steuereingang MOD sowie ein Eingang TES zum Auslösen der Erstsynchronisation verbunden, an den ein entsprechender Eingang der Ablaufsteuerung AS angeschlossen ist.

Der erste Phasendiskriminator DIS1 bildet mit cem Schleifenfilter LF, dem spannungsgesteuerten Oszillator VCXO, dem ersten Wandler W1 sowie dem ersten Frequenzteiler T1 die eigentliche Phasenregelschleife. Beim Ausführungsbeispiel schwingt dabei der spannungsgesteuerte Oszillator VCXO auf einer Frequenz von 39 MHz, die durch den Frequenzteiler T1 auf eine Frequenz von etwa 2 MHz heruntergeteilt wird, die der Frequenz des vom gesteuerten Umschalter SS an den ersten Phasendiskriminator DIS1 abgegebenen Normaltaktsignal TN2X entspricht. Dabei wird von der Betriebs-Ersatz-Logikschaltung BE über den Anschluß MOD gesteuert im Betriebsfall das von der Eingangsschaltung ES abgegebene Normaltaktsignal TN2 weitergeleitet, im Ersatzfall wird stattdessen das Referenztaktsignal vom entsprechenden Eingang TRE zum Vergleichseingang des Phasendiskriminators DIS1 weitergeleitet. Der mit dem Eingang MOD verbundene Steuereingang des Schleifenfilters LF wird im Ersatzfall ebenfalls mit einem Schaltbefehl beaufschlagt, durch den das Schleifenfilter auf einen breiteren Durchlaßbereich und damit auf eine niedrigere Güte der gesamten Phasenregelschleife umgeschaltet wird. Durch die Verbindung zum ersten Ausgang AS1 der Schaltungsanordnung zur Ablaufsteuerung AS erhält das Schleifenfilter LF außerdem ein Steuersignal, durch den das Ausgangssignal des Schleifenfilters LF und damit die Steuerspannung des nachgeschalteten Oszillators auf einen konstanten Wert geschaltet wird, wenn in der Setzlogik SL1 eine Unregelmäßigkeit des Führungstaktes TN2X erkannt wird.

Im eingeschwungenen Zustand haben das Ausgangssignal TN2 der Eingangsschaltung ES und der intern erzeugte 2MHz-Takt und damit auch der Frequenzteiler T1 eine feste Phase zueinander. Aus dem Ausgangssignal TN2X des gesteuerten Umschalters SS wird in der ersten Setzlogik SL1, die außerdem eine Fehlerüberwachungseinrichtung enthält, ein Pulssignal abgeleitet, das im eingeschwungenen Zustand mit einem für die Teilerphase und damit für die interne 2MHz-Taktphase charakteristischen Pulssignal übereinstimmt. In diesem Fall arbeitet die gesamte Anordnung als normale Phasenregelschleife. Bei einem Grobphasensprung, also einem die halbe Bittaktperiode überschreitenden Phasensprung, im Ausgangssignal TN2X des gesteuerten Umschalters SS stimmen diese Pulssignale nicht mehr überein, der Frequenzteiler T1 wird dann einmalig so gesetzt, daß die Pulssignale und damit die Grobphasen wieder übereinstimmen. Dabei wird das für die Phase des Ausgangssignals TN2 der Eingangsschaltung ES charakteristische Pulssignal durch Abtasten des Ausgangssignals des gesteuerten Umschalters SS mit dem Oszillatorausgangssignal und Differenzieren der positiven Flanke erzeugt und paßt damit in das Raster des Frequenzteilers T1, der ebenfalls über den ersten Wandler W1 das Oszillatorausgangssignal erhält. Die erste Setzlogik SL1 spricht dann nur bei Phasensprüngen des Ausgangssignals TN2X des Umschalters SS an, die in der Regel gleich oder größer einer halben Oszillatorausgangssignal-Periode sind. Der Fehlermonitor der ersten Setzlogik SL1 löst bei Unregelmäßigkeiten im Ausgangssignal TN2X des Umschalters SS die Ablaufsteuerung des Setzvorganges aus, in diesem Falle wird über den ersten Ausgang AS1 der Ablaufsteuerung AS das Schleifenfilter LF entsprechend angesteuert und die Steuerspannung des Oszillators für eine erste vorgegebene Zeit Z1 auf den letzten Wert konstant gehalten. Nach dieser Zeit wira die Setzlogik SL freigegeben und der erste Frequenzteiler T1 gesetzt. Anschließend wird nach einer weiteren vorbestimmten Zeit Z2 der in der ersten Setzlogik SL1 enthaltene Fehlermonitor aktiviert, der bei trotz Setzvorgang immer noch fehlerhafter Grobphase des Ausgangssignals des ersten Frequenzteilers FT1 für die erste Setzlogik SL1 einen entsprechenden Alarm auslöst. Ein weiterer Alarm wird ausgelöst, wenn im Ausgangssignal TN2X des Umschalters SS für eine Zeit von beispielsweise 100 ms kein Wechsel des Logikpegels auftritt, da in diesem Falle dieses Taktsignal ausgefallen sein muß.

In der Fig. 3 ist der in der Anordnung nach Fig. 1 enthaltene Lückentaktgenerator LTG in einem detaillierteren Blockschaltbild dargestellt. Entsprechend der Fig. 1 übernimmt der Lückentaktgenerator LTG von der Phasenregelschleife das in vom Oszillator VCXO erzeugte Bittaktsignal mit einer Frequenz von etwa 39 MHz, das vom Bittakteingang FE39 dem Signaleingang eines dritten Phasenschiebers PS3 zugeführt und von dessen Ausgang an den Signaleingang eines dritten Wandlers, der als Sinus-AC-MOS-Wandler ausgeführt ist. Der Steuereingang des dritten Phasenschiebers PS3 ist dabei mit dem Ausgang eines Feinphasenreglers FPR verbunden, der eingangsseitig an den Steuerausgang einer Alarmlogik AL und andererseits an den Ausgang eines zweiten Phasendiskriminators DIS2 angeschlossen ist. Der Referenzeingang des zweiten Phasendiskriminators DIS2 ist über den Anschluß TR39 mit dem Taktausgang der Phasenregelschleife PLL der gedoppelten Baugruppe verbunden. Der dritte Wandler W3 besitzt drei Ausgänge, von denen der erste über eine Schaltung zum Laufzeitausgleich LZA mit einem Vergleichseingang des zweiten Phasendiskriminators DIS2 verbunden ist, während ein zweiter Ausgang mit einem Eingang eines Überwachungszählers UZ und ein dritter Ausgang mit dem Signaleingang eines Rahmentaktzählers RTZ sowie mit dem Bittakteingang eines Ausgangssignaltreibers ATS verbunden ist. Dieser Ausgangssignaltreiber ist mit einer Schaltung zur Lückentakteinblendung LTE kombiniert, ein erster Eingang dieser Schaltung ist mit einem Ausgang des Rahmentaktzählers RTZ verbunden und kann die Schaltung zur Lückentakteinblendung LTE im Bedarfsfalle abschalten. Der Ausgangssignaltreiber ATS weist vier parallele Taktausgänge TA1... TA4 zur Steuerung einer nachgeschalteten Multiplexeranordnung auf, außerdem ist ein Meßausgang TR39MA und ein Überwachungsausgang UA vorgesehen, letzterer ist mit dem Eingang einer Schaltunganordnung zur Lückentaktüberwachung LTU verbunden, deren Ausgang mit einem zugeordneten Eingang der Alarmlogik AL verbunden ist. Der Steuersignaleingang SSE der Schaltungsanordnung zur Lückentaktüberwachung ist mit einem entsprechenden Ausgang einer zweiten Steuerlogik SL2 verbunden ist. Die zweite Steuerlogik SL2 ist dabei mit der Alarmlogik AL kombiniert. Weitere Steuerausgänge der zweiten Steuerlogik SL2 sind mit entsprechenden Eingängen des Rahmentaktzählers RTZ und der Zählerüberwachung UZ verbunden. Ein Synchroneingang des Rahmentaktzählers RTZ ist außerdem mit einem entsprechenden Eingang des Uberwachungszählers UZ und mit einem Anschluß TES für einen externen Synchrontakt verbunden, dieser Synchrontakt stammt vom Rahmentaktzähler der jeweils anderen Baugruppe. Ein weiterer Ausgang des Rahmentaktzählers RTZ ist mit einem zugeordneten Eingang des Überwachungszählers UZ verbunden, während dessen Alarmausgang mit einem zugeordneten Eingang der Alarmlogik AL verbunden ist. Die zweite Steuerlogik SL2 weist außerdem eine Reihe von Steuerbefehlseingängen SBE auf, die zur Übertragung von extern erzeugten Rücksetzimpulsen, Taktsynchronimpulsen sowie von Signalen dienen, die die Information über den momentanen Status der Betriebs-Ersatz-Schaltungslogik PW sowie die Synchronisation des Rahmentaktzählers und des Überwachungszählers betreffen.

Die Funktion des dritten Phasenschiebers PS3 ist die eines Stellgliedes im Feinphasenregelkreis, während sich die betreffende Baugruppe im Ersatzstatus befindet, so daß also in diesem Falle die Ersatzbaugruppe der Betriebsbaugruppe fein nachgeregelt wird. Beim Betriebszustand der betreffenden Baugruppe ist die Steuerspannung des dritten Phasenschiebers PS3 so eingestellt, daß dieser keine Phasenverschiebung verursacht. Der dritte Phasenschieber PS3 hat ein sinusförmiges Ausgangssignal, das für die weitere Verarbeitung vom dritten Wandler W3 in Form eines Sinus-AC-MOS-Wandlers in ein Rechtecksignal mit AC-MOS-Pegel und oem Tastverhältnis 1:2 umgewandelt wird. Der dritte Wandler W3 ist als integrierter Baustein aus mehrenen eingangsseitig parallelgeschalteten Treiberbausteinen realisiert.

Ebenfalls in AC-MOS-Technik ist der Rahmentaktzähler RTZ realisiert, der den Bittakt von etwa 39 MHz durch 19456 teilt und dadurch den gewünschten Lückentakt von 2 kHz erzeugt. Der Aufbau erfolgt dabei als Aufwärtszähler, der durch einen externen Setzpuls TSYNC parallel geladen werden kann. Der vom Rahmentaktzähler RTZ erzeugte Lückentakt wird als synchroner 2 Bit breiter Impuls im 2 kHz-Rhythmus an die Schaltung zur Lückentakteinblendung abgegeben.

Da die den Rahmenbeginn kennzeichnende Taktlücke im Bittaktsignal, also der Lückentakt, bitgenau stimmen muß, ist eine aufwendige Überwachung vorgesehen, um insbesondere ein Teilerspringen bzw. Zählerspringen im Rahmentaktzähler RTZ erfassen zu können. Der Überwachungszähler UZ ist deshalb völlig anders als der Rahmentaktzähler RTZ aufgebaut. Der Überwachungszähler arbeitet mit Abwärtszählen und damit nach einem anderen Zählprinzip, außerdem mit anderen Zählerbausteinen an einen separaten Takttreiber, und zusätzlich wird der Zähler mit einer anderen Taktflanke auf eine andere Zahl gesetzt, wobei natürlich das Frequenzteilerverhältnis von 19456:1 eingehalten werden muß. Ebenso wie der Rahmentaktzähler RTZ wird der Überwachungszähler UZ durch einen externen Synchronisierimpuls TES auf die im Betriebsstatus befindliche Baugruppe synchronisiert. Zur Überwachung des Teilersynchronismus zwischen Rahmentaktzähler RTZ und Überwachungszähler UZ werden die beiden Teilerausgänge in der Alarmlogik AL verglichen und bei fehlendem Synchronismus ein Alarmsignal erzeugt.

Wegen der hohen Genauigkeitsanforderungen bezüglich der Ausgangsphasen zwischen Betriebsbaugruppe und Ersatzbaugruppe wurde für den Ersatzbetrieb eine Feinphasenregelung vorgesehen, die mit dem dritten Phasenschieber PS3 als Stellglied, der Feinphasenreglung FPR, dem zweiten Phasendiskriminator DIS2, der Schaltung zum Laufzeitausgleich LZA und der Phasendifferenzüberwachung PDU relativ aufwendig aufgebaut ist.

Im zweiten Phasendiskriminator DIS2 wird das Ausgangssignal des dritten Wandlers W3 nach Durchlaufen der Schaltungsanordnung zum Laufzeitausgleich LZA mit dem in der parallelen Baugruppe erzeugten Taktreferenzsignal T39E verglichen und ein entsprechendes Signal an den Feinphasenregler FPR abgegeben. Da das Tastverhältnis aer beiden Eingangssignale des zweiten Phasendiskriminators DIS2 das Diskriminatorverhalten und die Regelung nicht beeinflussen darf, wurde ein flankengetriggerter Phasendiskriminator gewählt, der eine sägezahnförmige Charakteristik besitzt und von beiden Einsatzsignalen flankengetriggert wird. Das Ausgangssignal des zweiten Phasendiskriminators DIS2 wird außerdem in der Schaltung zur Phasendiskriminatorüberwachung PDU auf unzulässige Abweichungen der Lückentaktphase überwacht und im Fehlerfall eine entsprechendes Signal an die Alarmlogik AL abgegeben, die dann ein entsprechendes Alarmsignal erzeugt und außerdem dann ein Schaltsignal an den Feinphasenregler FPR abgibt. Der Feinphasenregler hat die Aufgabe, das vom Phasendiskriminator als Rechteckspannung mit veränderlichem Tastverhältnis abgegebene Ausgangssignal zu integrieren und in eine Steuerspannung für den dritten Phasenschieber PS3 umzuwandeln.

Die Erstsynchronisation des gesamten Lückentaktgenerators wird von der Betriebs-Ersatz-Logikschaltung BE eingeleitet indem diese entsprechende Steuerbefehle an die zweite Steuerlogik SL2 abgibt. Zur Erstsynchronisation werden dazu auf die empfangenen Steuerbefehle hin von der zweiten Steuerlogik SL2 Steuerbefehle an den Rahmentaktzähler RTZ und den Überwachungszähler UZ abgegeben und dadurch veranlaßt, daß beide Bausteine aufeinander synchronisieren. Bleibt die gesamte Baugruppe im Betriebsstatus, dann müssen Überwachungszähler und Rahmentaktzähler synchron sein. Wird vom Betriebszustand auf den Ersatzzustand umgeschaltet, wird das Einschwingen des Feinphasenregelkreises veranlaßt. Dazu wird durch einen Steuerbefehl der Alarmlogik AL der Feinphasenregler von einer festen Ausgangsspannung als Referenzspannung auf die Ausgangsspannung des zweiten Phasendiskriminators DES2 umgeschaltet, abschließend erfolgt im Ersatzbetrieb die Synchronisation des Rahmentaktzählers und des Überwachungszählers UZ. Die jeweiligen Synchronisationsvorgänge werden ebenso wie die Vorgänge während des Betriebes durch die Überwachungseinrichtungen überwacht und durch die Kombination aus Alarmlogik AL und zweiter Steuerlogik SL2 ausgewertet.

## Patentansprüche

1. Verfahren zur Taktsignalerzeugung für gedoppelte Systeme, insbesondere für kombinierte Multiplex- und Vermittlungseinrichtungen für digitale Signale mit einer Betriebsbaugruppe und einer Ersatzbaugruppe, die jeweils eine Phasenregelschleife mit nachgeschaltetem Frequenzteiler zur Erzeugung eines höherfrequenten Bittaktsignals in Abhängigkeit von einem niedrigerfrequenten Normaltaktsignal des gedoppelten Systems und einen Leitungstaktgenerators enthalten,
**dadurch gekennzeichnet,**
daß zur Erzeugung eines hochfrequenten Bittaktsignals mit vergleichsweise langperiodisch auftretenden Unterbrechungen oder Lücken vergleichsweise kurzer Dauer das Normaltaktsignal des gedoppelten Systems mit einem örtlich erzeugten Bittaktsignal abgetastet und dadurch die Grobphase des Normaltaktsignals ermittelt und ein entsprechendes Grobphasen-Pulssignal erzeugt wird,
daß Phasensprünge bis zu einer halben Bitperiode des Bittaktsignals durch die Phasenregelschleife (PLL) selbst ausgeregelt werden und bei größeren Phasensprüngen der nachgeschaltete Frequenzteiler (T1) mit dem Grobphasen-Pulssignal neu gesetzt wird, so daß größere Phasensprünge des Normaltaktsignals durch Phasensprünge des Grobphasen-Pulssignals angenähert werden, ohne daß sich dies auf die Phase des Bittaktsignals auswirkt,
daß bei Unregelmäßigkeiten, also Phasensprüngen oder Unterbrechungen des Normaltaktes in der Betriebsbaugruppe oder Phasensprüngen im Referenztakt der Ersatzbaugruppe die Phasenregelschleife (PLL) für eine erste Zeit (Z1) aufgetrennt und der Steuereingang des spannungsgesteuerten Oszillators (VCXO) der Phasenregelschleife (PLL) auf dem letzten Wert konstant gehalten wird,
daß nach dieser ersten Zeit (Z1) der mit dem spannungsgesteuerten Oszillator verbundene erste Frequenzteiler (T1) mit dem Grobphasen-Pulssignal einmalig gesetzt und die Phasenregelschleife (PLL) wieder geschlossen wird,
daß nach einer weiteren Zeit (Z2) zum Durchlaufen etwaiger Entscheiderunsicherheitsbereiche die Phasenübereinstimmung überprüft wird,
und daß damit die Bittaktausgänge der Phasenregelschleifenteile zueinander durch Grobphasensprünge überhaupt nicht und, durch Güteumschaltung der Phasenregelschleife (PLL) der Ersatzbaugruppe bedingte Feinphasensprünge nur um höchstens ein Viertel der Bittaktperiode differieren können, so daß die Speisung der Teile des Leitungstaktgenerators (LTG) mit dem erzeugten Bittaktsignal unter Einhaltung der Phaseneindeutigkeit und eine Phasenregelung der Teile des Leitungstaktgenerators (LTG) durch Bitratenvergleich möglich ist.

2. Verfahren nach Patentanspruch 1,
**dadurch gekennzeichnet,**
daß die Phase des Lückentakts der Ersatzbaugruppe auf die Phase des Lückentaktes der Betriebsbaugruppe durch Vergleich der Bittaktsignale fein nachgeregelt wird.

3. Anordnung zur Durchführung eines Verfahrens zur Taktsignalerzeugung für gedoppelte Systeme, für kombinierte Multiplex- und Vermittlungseinrichtungen für digitale Signale mit einer Betriebsbaugruppe und einer Ersatzbaugruppe, die jeweils eine Phasenregelschleife mit nachgeschaltetem Frequenzteiler zur Erzeugung eines höherfrequenten Bittaktsignals in Abhängigkeit von einem niedrigerfrequenten Normaltaktsignal des gedoppelten Systems und einen Leitungstaktgenerators enthalten nach Anspruch 1 oder 2,
**dadurch gekennzeichnet,**
daß in der Betriebsbaugruppe im Anschluß an eine Eingangsfilterschaltung eine Phasenregelschleife (PLL) vorgesehen ist,
die in an sich bekannter Weise die Reihenschaltung eines ersten Phasendiskriminators (DIS1), eines Schleifenfilters (LF) und eines spannungsgesteuerten Oszillators (VCXO) enthält und auf die Frequenz des Bittaktsignals abgestimmt ist,
daß die Phasenregelschleife (PLL) einen ersten Frequenzteiler (T1) mit einem solchen Teilerverhältnis enthält,
daß sich ein Teilerausgangssignal mit einer Frequenz entsprechend dem Normaltaktsignal (TN1) ergibt,
daß ein erster Ausgang des ersten Frequenzteilers (T1) mit einem ersten und ein Normaltakteingang (TN2E) mit einem zweiten Eingangsanschluß des ersten Phasendiskriminators (DIS1) verbunden ist,
daß ein erster Ausgang des Oszillators (VCXO) mit einem zweiten Frequenzteiler in Form eines Rahmentaktzählers (RTZ) verbunden ist, dessen Teilerverhältnis so gewählt ist, daß sich ein Teilerausgangssignal mit einer Periode entsprechend den langperiodisch auftretenden Taktlücken ergibt,
daß mit dem Ausgang des Rahmentaktzählers (RTZ) ein erster und mit dem Ausgang des Oszillators gegebenenfalls über einen Phasenschieber (PS3) und einen Wandler (W3) ein zweiter Eingang einer Anordnung (LTE) zur Lückentakteinblendung in Form eines gesteuerten Schalters verbunden sind, der für die Dauer der Taktlücken die Weiterleitung des Oszillatorausgangssignals unterbricht,
daß Ersatzbaugruppe und Betriebsbaugruppe gleich aufgebaut sind und ihren jeweiligen Status durch ein Steuersignal einer Betriebs-Ersatz-Logikschaltung (BE) erhalten.

4. Anordnung nach Patentanspruch 3,
**dadurch gekennzeichnet,**
daß mit dem Rahmentaktzähler (RTZ) ein Überwachungszähler (UZ) zusammengeschaltet ist, der in unterschiedlicher Schalttechnik aufgebaut ist, nach einem anderen Teil- bzw. Zählprinzip arbeitet, einen eigenen Betriebstakt besitzt und jeweils die andere Flanke der Zähl- bzw. Teilimpulse auswertet.

5. Anordnung nach Patentanspruch 3,
**dadurch gekennzeichnet,**
daß der Durchlaßbereich des Schleifenfilters (LF) der Phasenregelschleife der Ersatzbaugruppe gegenüber dem der Betriebsbaugruppe vergrößert und damit die Güte der Phasenregelschleife der Ersatzbaugruppe verringert ist.

## Claims

1. Method for clock signal production for duplicated systems, in particular for combined multiplex and switching devices for digital signals having an operating assembly and a standby assembly, which each contain a phase locked loop with a downstream frequency divider in order to produce a higher frequency bit clock signal as a function of a lower frequency normal clock signal of the duplicated system and each contain a line clock generator,
characterized in that
in order to produce a high frequency bit clock signal with interruptions or gaps (which occur at comparatively long periods) of comparatively short duration, the normal clock signal of the duplicated system is sampled using a locally produced bit clock signal and the rough phase of the normal clock signal is determined in this way and a corresponding rough phase pulse signal is produced,
in that phase jumps up to half a bit period of the bit clock signal are smoothed out by the phase locked loop (PLL) itself, and in the event of greater phase jumps, the downstream frequency divider (T1) is reset using the rough phase pulse signal such that greater phase jumps in the normal clock signal are approximated to by phase jumps in the rough phase pulse signal without this having any effect on the phase of the bit clock signal,
in that, in the event of irregularities, that is to say phase jumps or interruptions in the normal clock in the operating assembly or phase jumps in the reference clock of the standby assembly, the phase locked loop (PLL) is disconnected for a first time (Z1), and the control input of the voltage controlled oscillator (VCXO) of the phase locked loop (PLL) is held constant at the last value,
in that, after this first time (Z1), the first frequency divider (T1) (which is connected to the voltage controlled oscillator) is set once using the rough phase pulse signal and the phase locked loop (PLL) is connected again, in that, after a further time (Z2) for passing through any decision uncertainty regions, the phase correspondence is checked,
and in that, in order that the bit clock outputs of the phase locked loop parts cannot differ from one another at all as a result of rough phase jumps and differ by only at most one quarter of the bit clock period as a result of fine phase jumps caused by changing the quality factor of the phase locked loop (PLL) in the standby assembly, so that it is possible to supply the parts of the line clock generator (LTG) with the produced bit clock signal while maintaining the phase unambiguity, and the phase of the parts of the line clock generator (LTG) can be controlled by bit rate comparison.

2. Method according to Patent Claim 1,
characterized in that
the phase of the gap clock of the standby assembly is finely slaved to the phase of the gap clock of the operating assembly by comparison of the bit clock signals.

3. Arrangement for carrying out a method for clock signal production for duplicated systems, in particular for combined multiplex and switching devices for digital signals having an operating assembly and a standby assembly, which each contain a phase locked loop with a downstream frequency divider in order to produce a higher frequency bit clock signal as a function of a lower frequency normal clock signal of the duplicated system, and each contain a line clock generator, said method being according to Claim 1 or 2,
characterized in that
in the operating assembly, an input filter circuit is followed by a phase locked loop (PLL),
which, in a manner known per se, contains the series circuit of a first phase discriminator (DIS1), a loop filter (LF) and a voltage controlled oscillator (VCXO) and is tuned to the frequency of the bit clock signal,
in that the phase locked loop (PLL) contains a first frequency divider (T1) with a division ratio such that a divider output signal is produced at a frequency corresponding to the normal clock signal (TN1),
in that a first output of the first frequency divider (T1) is connected to a first input connection of the first phase discriminator (DIS1), and a normal clock input (TN2E) is connected to a second input connection of the first phase discriminator (DIS1),
in that a first output of the oscillator (VCXO) is connected to a second frequency divider in the form of a frame clock counter (RTZ) whose division ratio is chosen such that a divider output signal is produced with a period corresponding to the clock gaps which occur at long periods,
in that the output of the frame clock counter (RTZ) has connected to it a first input of an arrangement (LTE) for gap clock overlaying, and the output of the oscillator has connected to it, possibly via a phase shifter (PS3) and a converter (W3), a second input of said arrangement (LTE), this arrangement (LTE) being in the form of a controlled switch which stops the oscillator output signal being passed on for the duration of the clock gaps,
and in that the standby assembly and the operating assembly are of identical construction and are given their respective status by a clock signal from an operating/standby logic circuit (BE).

4. Arrangement according to Patent Claim 3,
characterized in that
the frame clock counter (RTZ) has connected to it a monitoring counter (UZ) which is constructed using a different switching technique, using a different division and/or counting principle, has its own operating clock and in each case evaluates the other flank of the counting and/or division pulses.

5. Arrangement according to Patent Claim 3,
characterized in that
the passband of the loop filter (LF) in the phase locked loop of the standby assembly is greater than that of the operating assembly, and the quality factor of the phase locked loop in the standby assembly is reduced in this way.

## Revendications

1. Procédé pour la génération d'un signal d'horloge pour des systèmes doublés, particulièrement pour des installations combinées de multiplexage et de commutation pour des signaux numériques, avec un module de service normal et un module de secours, qui comprennent chacun une boucle de régulation de phase, suivie en aval d'un diviseur de fréquence pour la génération d'un signal de rythme numérique à haute fréquence en fonction d'un signal d'horloge normal à basse fréquence du système doublé, et un générateur de signal d'horloge de ligne
**caractérisé**
par le fait que, pour la génération du signal de rythme numérique à haute fréquence avec des interruptions apparaissant selon un cycle relativement long ou des intervalles entre impulsions d'une durée relativement courte, le signal d'horloge normal du système doublé est balayé par un signal de rythme numérique généré localement et, ainsi, la phase approximative du signal d'horloge normal est déterminée et un signal pulsé de phase approximative correspondant est généré,
par le fait que des sauts de phase, allant jusqu'à la moitié du cycle du signal de rythme numérique, sont régulés par la boucle de régulation de phase (PLL) elle-même et que, en cas de sauts de phase plus importants, le diviseur de fréquence (T1) placé en aval de la boucle de régulation de phase est repositionné par le signal pulsé à phase approximative de telle sorte que des sauts de phase plus importants du signal d'horloge normal sont approchés par des sauts de phase du signal pulsé à phase approximative sans que ceci ait une influence sur la phase du signal de rythme numérique,
par le fait que, en cas d'irrégularités, donc en cas de sauts de phase ou d'interruptions du signal d'horloge normal dans le module en service normal ou de sauts de phase dans le signal d'horloge de référence du module de secours, la boucle de régulation de phase (PLL) est interrompue pour un premier temps (Z1) et l'entrée de commande de l'oscillateur piloté par la tension (VCXO) de la boucle de régulation de phase (PLL) est maintenue constante sur la dernière valeur,
par le fait que, après ce premier temps (Z1), le premier diviseur de fréquence (T1) relié à l'oscillateur piloté par la tension est positionné une seule fois par le signal pulsé à phase approximative et la boucle de régulation de phase (PLL) est rétablie,
par le fait que, après une autre période de temps (Z2) pour laisser passer des zones d'incertitude de décision, la concordance de phase est vérifiée,
et par le fait qu'ainsi les sorties de rythme numérique des composantes de la boucle de régulation de phase ne peuvent pas du tout différer entre elles par des sauts de phase approximative et les sauts de phase fine provoqués par la commutation de la qualité de la boucle de régulation de phase (PLL) du module de secours ne peuvent différer au maximum que d'un quart de cycle du rythme numérique de telle sorte que l'alimentation des composantes du générateur du signal d'horloge de ligne (LTG) avec le signal de rythme numérique généré est possible tout en maintenant parfaitement la concordance de phase et qu'une régulation de phase des composantes du générateur du signal d'horloge de ligne (LTG) est possible grâce à une comparaison des débits binaires.

2. Procédé conforme à la revendication 1,
**caractérisé**
par le fait que la phase du rythme d'intervalles entre impulsions du module de secours suit une régulation fine sur la phase du rythme d'intervalles entre impulsions du module de service normal grâce à une comparaison des signaux du rythme numérique.

3. Montage pour la mise en oeuvre d'un procédé, conforme à la revendication 1 ou à la revendication 2, pour la génération d'un signal d'horloge pour des systèmes doublés pour des installations de multiplexage et de commutation de signaux digitaux avec un module de service normal et un module de secours qui comportent chacun une boucle de régulation de phase avec un diviseur de fréquence raccordé en aval pour la génération d'un signal de rythme numérique à haute fréquence en fonction d'un signal d'horloge normal à basse fréquence du système doublé et un générateur de signal d'horloge de ligne,
**caractérisé**
par le fait que, dans le module de service normal, une boucle de régulation de phase (PLL) est prévue en aval d'un circuit de filtrage d'entrée, cette boucle de régulation de phase comprenant, d'une façon connue en soi, un montage en série d'un premier discriminateur de phase (DIS1), d'un filtre à boucle (LF) et d'un oscillateur piloté par la tension (VCXO) et étant réglée sur la fréquence du signal de rythme numérique,
par le fait que la boucle de régulation de phase (PLL) comporte un premier diviseur de fréquence (T1) ayant un rapport de division tel qu'il en résulte un signal de sortie du diviseur avec une fréquence correspondant au signal d'horloge normal (TN1),
par le fait qu'une première sortie du premier diviseur de fréquence (T1) ) est reliée à un premier raccordement d'entrée du premier discriminateur de phase (DIS1) et qu'une entrée du signal d'horloge normal (TN2E) est reliée à un deuxième raccordement d'entrée du premier discriminateur de phase (DIS1),
par le fait qu'une première sortie de l'oscillateur (VCXO) est reliée à un deuxième diviseur de fréquence ayant la forme d'un compteur de signaux de trame (RTZ) dont le rapport de division est choisi de telle sorte qu'il en résulte un signal de sortie du diviseur ayant une période équivalant aux intervalles entre impulsions apparaissant périodiquement à des instants éloignés l'un de l'autre,
par le fait qu'une première entrée d'un montage (LTE) pour l'insertion du rythme des intervalles entre impulsions ayant la forme d'un commutateur asservi est reliée à la sortie du compteur de signaux de trame (RTZ) et qu'une deuxième entrée de ce montage (LTE) est reliée à la sortie de l'oscillateur, le cas échéant, à travers un déphaseur (PS3) et un convertisseur (W3), ce commutateur asservi interrompant la transmission du signal de sortie de l'oscillateur pour la durée des intervalles entre impulsions,
par le fait que le module de secours et le module de service normal sont constitués de la même façon et qu'ils reçoivent leur statut respectif par un signal de commande d'un circuit logique normal / secours (BE).

4. Montage conforme à la revendication 3
**caractérisé**
par le fait qu'avec un compteur de signaux de trame (RTZ) est interconnecté un compteur de supervision UZ, qui est monté suivant une technique de circuit différente, qui travaille sur un autre principe de division ou de comptage, qui possède un propre rythme de fonctionnement et qui analyse l'autre flanc respectif des impulsions de comptage ou de division.

5. Montage conforme à la revendication 3
**caractérisé**
par le fait que la bande passante du filtre à boucle (LF) de la boucle de régulation de phase du module de secours est plus large que celle du module de service normal et qu'ainsi, la qualité de la boucle de régulation de phase du module de secours est diminuée.
